# EUROPEAN PATENT SPECIFICATION

(11) **EP 2 960 989 B1**
(45) Date of publication and mention of the grant of the patent: **02.05.2018**
(21) Application number: 15170966.4
(22) Date of filing: 08.06.2015
(51) Int. Cl.: H01Q 25/00, H01Q 9/04, H01Q 21/00, H01Q 1/32, H01Q 3/40, H01Q 21/06

(54) **A COUPLING ARRANGEMENT AND A COUPLING METHOD FOR A SWITCHABLE MULTI-BEAM ANTENNA**
KOPPLUNGSANORDNUNG UND KOPPLUNGSVERFAHREN FÜR EINE ANTENNE MIT UMSCHALTBAREN STRAHLUNGSKEULEN
AGENCEMENT DE COUPLAGE ET PROCEDE DE COUPLAGE POUR UNE ANTENNE AVEC PLUSIEURS LOBES COMMUTABLE

(30) Priority: 26.06.2014 FI 20145619
(43) Date of publication of application: 30.12.2015
(73) Proprietor: Bittium Wireless Oy, 90590 Oulu (FI)
(72) Inventor: Haarakangas, Tuomo, 90590 Oulu (FI); Purkunen, Esa, 90590 Oulu (FI); Uhari, Ilkka, 90590 Oulu (FI)
(74) Representative: Kolster Oy Ab

(56) References cited:
- EP-A2- 2 474 436
- WO-A1-2007/149046
- DE-A1- 10 057 564
- DE-A1- 19 951 123
- US-A- 6 014 066
- US-B1- 6 686 867
- CARSTEN METZ ET AL: "Fully Integrated Automotive Radar Sensor With Versatile Resolution", IEEE TRANSACTIONS ON MICROWAVE THEORY AND TECHNIQUES, IEEE SERVICE CENTER, PISCATAWAY, NJ, US, vol. 49, no. 12, 1 December 2001 (2001-12-01), XP011038526, ISSN: 0018-9480
- QASIM A M ET AL: "A compact & high gain series array planar antenna for 60-GHz WPAN applications", APPLIED ELECTROMAGNETICS (APACE), 2010 IEEE ASIA-PACIFIC CONFERENCE ON, IEEE, 9 November 2010 (2010-11-09), pages 1-5, XP031981071, DOI: 10.1109/APACE.2010.5720110 ISBN: 978-1-4244-8565-9

## Description

### Field

The invention relates to a coupling arrangement and a coupling method.

### Background

An integrated structure for multi beam antenna is needed to provide a simple, reliable, and easy to manufacture solution with good radio frequency performance in a cost and size effective manner. These parameters are required in a mast assembled remote radio head, which also includes an antenna, for example.

In the prior art, there have been attempts to fulfill the requirements of a multi-beam antenna using multiple printed wiring boards (PWB) with several signal paths, a plurality of cables, and multiple milled mechanical parts. The directivity of the multi beam antenna have been realized with a rotational mechanics and in a three-dimensional structure has been utilized as an attempt to keep the total volume of the structure as small as possible.

Document Carsten Metz et al: "Fully Integrated Automotive Radar Sensor With Versatile Resolution", IEEE Transactions on microwave theory and techniques, IEEE service center, Piscataway, NJ, US, vol. 49, no 12, 1 December 2001 (2001 - 12 - 01), XP011038526, ISSN: 0018-9480 presents a planar radar sensor for automotive application.

Patent document WO 2007149046 presents quasi-planar circuits with air cavities.

Patent document DE 10057564 presents a control network for antenna arrangement of radar sensor, which has at least two coupling terminals on secondary side for connection to antenna arrangement.

Patent document US 6686867 presents a radar sensor and a radar antenna for monitoring the environment of a motor vehicle.

Patent document DE 19951123 presents a radar sensor and a radar antenna for monitoring the environment of a motor vehicle.

Patent document EP 2474436 presents a switched beam antenna architecture. Document A.M. Qasim and T. A. Rahman, "A Compact & High Gain Series Array Planar Antenna for 60-GHz WPAN Application," Proc. of 2010 IEEE Conference on Applied Electromagnetics (APACE 2010), Port Dickson, Negeri Sembilan, Malaysia, 2010, pp. 1-5 discloses series fed path antenna arrays with parasitic stacked patches.

Patent document US 6014066 discloses PIN diode based switches with a high isolation and good matching. However, this kind of solution has problems. The reliability of the prior art multi-beam antenna is not high enough. That is a result of the facts which are also problems as such: the tolerances are too high, and the plurality of cables is an unwanted feature. Also the size and shape still remain a problem. Hence, there is a need for improvement.

### Brief description

The present invention seeks to provide an improvement. According to an aspect of the present invention, there is provided a coupling arrangement as specified in claim 1.

According to another aspect of the present invention, there is provided a coupling method in claim 11.

The invention has advantages. The integration level is high which enables a low profile design and high reliability.

### List of drawings

Example embodiments of the present invention are described below, by way of example only, with reference to the accompanying drawings, in which
Figure 1 illustrates an example of an arrangement for a radio frequency multi-beam antenna;
Figure 2 illustrates example of coupling arrangement;
Figure 3 illustrates of an example of mechanical structure of a low profile patch antenna;
Figure 4 illustrates an example of electrically controllable switches;
Figure 5 illustrates another example of electrically controllable switches; and
Figure 6 illustrates of an example of a flow chart of the method.

### Description of embodiments

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned.

It should be noted that while Figures illustrate various embodiments, they are simplified diagrams that only show some structures and/or functional entities. The connections shown in the Figures may refer to logical or physical connections. It is apparent to a person skilled in the art that the described apparatus may also comprise other functions and structures than those described in Figures and text. It should be appreciated that details of some functions, structures, and the signalling used for measurement and/or controlling are irrelevant to the actual invention. Therefore, they need not be discussed in more detail here.

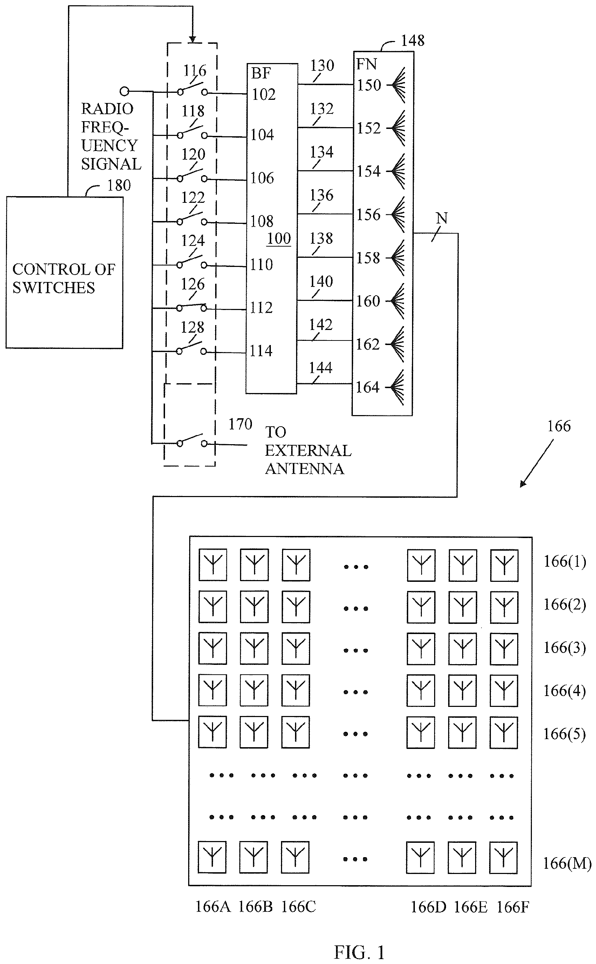

Figure 1 presents an example of a system related to a coupling arrangement for a radio frequency multi-beam antenna which may also be called an active antenna. The coupling arrangement comprises a beam former 100, which is electrically steerable, and the beam former 100 outputs the radio frequency signal in a steered beam form from at least one beam former output 130 to 144. The control signal for steering the beams may come from a controller 180. The control signal may control the beam forming of the beam former 100 directly or its inputs 102 to 114. The steering under control may make it possible to direct the beam continuously in the horizontal direction or the steering may be discrete in horizontal direction.

In an embodiment, the beam former 100 may comprise at least two electrically exclusively selectable beam former inputs 102 to 114 for a radio frequency signal input to the beam former 100. The expression "exclusively selectable" means that only one input 102 to 114 of the beam former 100 may be selected at any one selection moment for the radio frequency signal. At some other moment, the radio frequency signal may be fed to or received by another input 102 to 114.

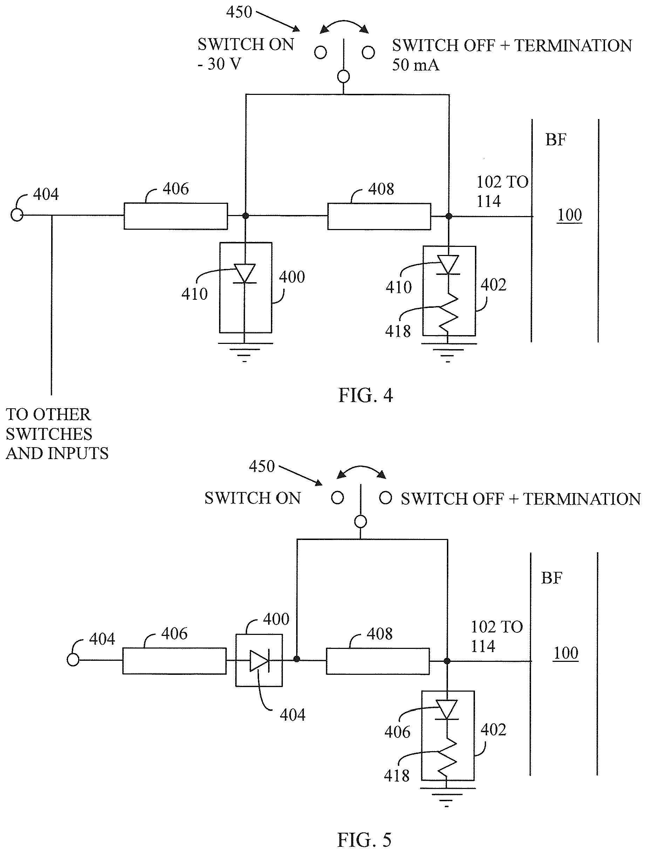

In an embodiment, the beam former input 102 to 114 may be selected by electrically controllable switches 116 to 128. In an embodiment the electrically controllable switches 116 to 128 may be associated with the beam former 100. In an embodiment, the electrically controllable switches 116 to 128 may be separate from the beam former 100. In an embodiment, the electrically controllable switches 116 to 128 may comprise diode switches (see Figures 4 and 5). The electrically controllable switches 116 to 128 may receive the radio frequency signal and couple the radio frequency signal to one of beam former inputs 102 to 114 at a time on the basis of a control signal fed to the switches 116 to 128. The radio frequency signal may also be fed to an external antenna through a switch 170.

The beam former 100 outputs the radio frequency signal from at least one beam former output 130 to 144. In an embodiment, the at least one output 130 to 144 may depend on the selected beam former input 102 to 114 or the at least one output 130 to 144 is a function of the beam former input 102 to 114. In an embodiment, the beam former 100 outputs the radio frequency signal through all outputs 130 to 144.

In an embodiment, the beam former 100 outputs the radio frequency signal through only one output 130 to 144. The beam former 100 performs a beam former input-dependent beam forming to the radio frequency signal passing through the beam former 100. The beam forming in the beam former 100 may be based on Rotman lens, for example. The beam shape is determined by phase shifts.

In an embodiment, the beam former 100 outputs the radio frequency signal in a beam-former-input-dependent beam form from beam former outputs 130 to 144. The radio frequency signal has thus a predetermined phase and power at each output 130 to 144 for forming a desired antenna beam.

A feed network structure 148 has a plurality of network inputs 150 to 164. Each of the inputs 150 to 164 is coupled with one beam former output 130 to 144. That is, there may be a one-to-one correspondence between the outputs 30 to 144 of the beam former 100 and the inputs 150 to 164 of the feed network structure 148. Hence, each of the network inputs 150 to 164 is typically coupled with only one beam former output 130 to 144. The feed network structure 148 is coupled with the capacitive feed structures 166 for forwarding the radio frequency signal to the feed structures 166 and for transmitting the radio frequency signal then via feed structure-specific radiators. In an embodiment, the feed structures 166 and the feed structure-specific radiators may be patch antennas.

In an embodiment, the feed network structure 148 may couple each network input 150 to 164 with all feed structures 166. In an embodiment, the feed network structure 148 may couple one or more network inputs 150 to 164 with only a part of the feed structures 166.

There may be parallel networks of the feed network structure 148 such that each network is for one vertical antenna element column/array (166(i), 166A), (166(i), 166B), (166(i), 166C), (166(i), 166D), (166(i), 166E) and (166(i), 166F), where i is one of 1, ..., M, and M x F = N. In general, the number of antenna elements may be k x j, where at least one of k and j is more than one and k and j are positive integers. The numbers k and j may be the same or they may be different i.e. there may be the same number of antenna elements in a vertical direction as in a horizontal direction or a different number of antenna elements in a vertical direction from that in a horizontal direction.

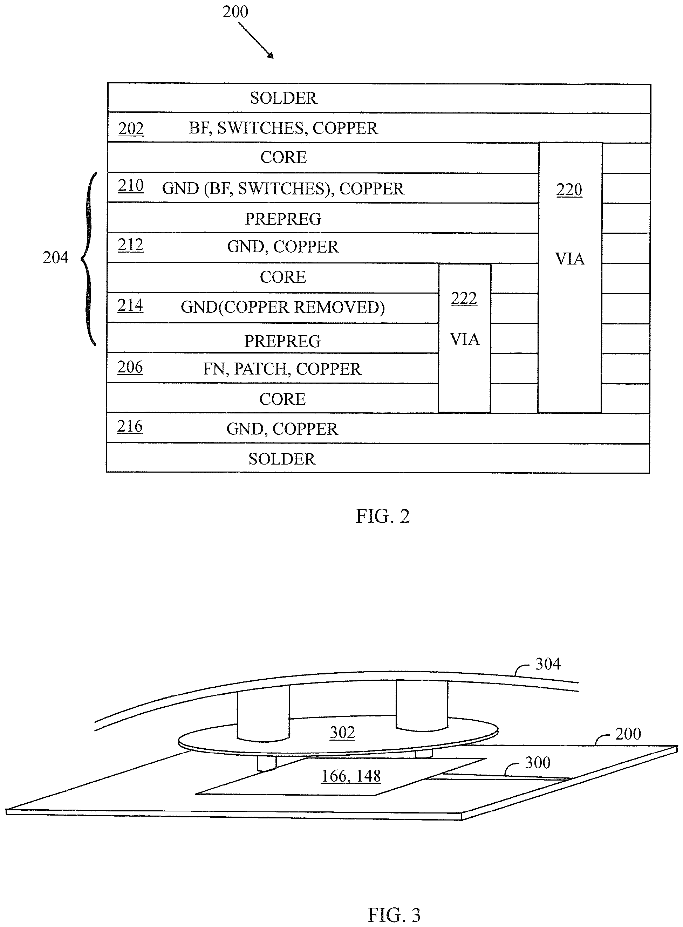

Examine now Figure 2 which presents an example of the coupling arrangement which comprises a multi-layered printed board 200.

Printed board (PB) is a generic name for a board which has electric circuits but PB has a plurality of names. Printed wiring board (PWB) also refers to a printed board. Printed circuit board (PCB) is another name for a printed board. The name may typically be used for a multi-layered board structure. Printed wire assembly (PWA) is an old name for a printed board. Printed circuit assembly (PCA) is another name for a printed board. Printed circuit board assembly (PCBA) is still another name for a printed board which is preferred by certain professionals.

The printed board 200 comprises a first layer structure 202, at least one ground layer structure 204 and a second layer structure 206.

The first layer structure 202 comprises the beam former 100, which is, as explained earlier, electrically steerable, and the beam former 100 outputs the radio frequency signal in a steered beam form from the at least one beam former output 130 to 144. The first layer structure 202 is a laminate structure which also comprises a core which may be made of ceramics or composite reinforcements. A core layer may be pre-impregnated with one or more thermoplastic resins in which case it may be called a prepreg. The core maybe made of Taconic RF material such as Taconic RF 35A2 or the like. The core layers support the electrically conductive layers on one surface or both surfaces of each core layer.

The first layer structure 202 may be covered with a solder layer and it may be considered that the solder layer is a part of the first layer structure 202.

The beam former 100 of the first layer structure 202 may comprise the at least two electrically exclusively selectable beam former inputs 102 to 114 for a radio frequency signal. The beam former 100 may output the radio frequency signal in a beam-former-input-dependent beam form from at least one beam former output 130 to 144 such that the beam form depends on the selected beam former input 102 to 144. Each beam form refers to a phase shifting of the radio frequency signals at beam former outputs 130 to 144.

The first layer structure 202 has the connectors for the radio head. The radio frequency signal is fed to the layer 202, and the radio frequency signal may be fed by a single connection having radio frequency signal and control signals. The radio frequency signal may be fed by a single connection (connector, tube etc.) and the control signals may be fed with a single connector.

Antenna beam selection switches 116 to 128 and microstrip lines for conducting the radio frequency signal may also be on this first layer structure 202. The first layer structure 202 may also comprise the at least one electronically controllable switch.

The first layer structure 202 may be grounded from the sides of the printed wiring board to the antenna unit mechanics, but isolated electrically from the unit mechanics in other areas.

The second layer structure 206 comprises the feed network structure 148 and the capacitive feed structures 166. The feed network structure 148 may comprise asymmetric strip lines. The starting points of the feeding lines of the feed network structure 148 may be connected to the beam former 100 through via 220 in the printed board 200.

The second layer structure 206 comprises the feed network 148 and capacitive feed structures 166. Also the second layer structure 206 comprises a core layer similar to other core layers of the multi-layered printed board 200. The second layer structure 206 may be covered with an additional ground layer structure 216.

The bottom layer i.e. layer 206 or layer 216 may be set to be towards the antenna radiators 302 and radome 304 which is a cover of the antenna. The ground layer 216 may be connected to other grounds through via 220 and/or via 222.

The at least one ground layer structure 204 provides electrical reference ground for the electric circuits of the beam former 100, electrically controllable switches 116 to 128, the feed network structure 148 and the capacitive feed structures 166. Similarly to the first layer structure 202, the at least one ground layer 204 has one or more support layers made of ceramics or composite reinforcements.

Figure 3 shows an example of a mechanical structure of a low profile patch antenna element which is similar to antenna elements of the feed structures 166. The part of the multi-layered printed board 200 dedicated for this patch antenna element has a transmission line 300 for receiving the radio frequency signal. The radio frequency signal has passed through the different electric circuits of the multi-layered printed board 200 elsewhere. The radio frequency signal propagates to the feed structure 166 of the feed network structure 148 which couples the radio frequency signal capacitively to a radiator 302 which transmits the radio frequency signal as electromagnetic radiation to the environment. The antenna element may be protected by a radome 304 which may be integrated to the radiator 302. The radome 304 protects the antenna against weather and environmental conditions, for example.

In an embodiment, the radome 304 may be made of plastic or polymer, for example, and the plastic/polymer radome 304 may be integrated to the radiator 302 either during the production of the plastic/polymer part or afterwards in an assembly process. The radome 304 may be about 0.5 mm thick. There is no need for additional support system for the radiator 302 or separate antenna radome. Separate antenna radome would increase size, cost and weight. With this intelligent structure, the antenna element is mostly air filled which means high gain, low loss, good efficiency and good bandwidth performance for the antenna element.

In an embodiment, the feed network structure 148 is coupled with the capacitive feed structures 166 for forwarding the radio frequency signal of the beam former input-dependent and network input-dependent beam form to the feed structures 166 for transmitting the radio frequency signal via feed structure-specific radiators 302.

In an embodiment, the first layer structure 202 comprises electrically controllable switches 116 to 128 associated with the beam former 100. The electrically controllable switches 116 to 128 may be a part of the beam former 100 or coupled with the beam former 100 inputs 102 to 114. The electrically controllable switches 116 to 128 may receive the radio frequency signal and couple the radio frequency signal to one of beam former inputs 102 to 114 at a time on the basis of the control signal.

In an embodiment, the feed network structure 148 may couple each of the beam former output 130 to 144 to one of the horizontally distributed feed structures 166 such that different beam former output 130 to 144 is coupled with horizontally different feed structure 166A to 166F. That is, one beam former output 130 to 144 is coupled with only one feed structure 166A to 166F in horizontal direction in order to steer the horizontal direction of the transmitted beam. The coupling between beam former outputs 130 to 144 and the horizontal feed structures 166A to 166F is made in a suitable order with respect to the phase shifts of the radio frequency signals at the outputs 130 to 144 of the beam former 100.

In an embodiment, the feed network structure 148 may couple each beam former output 130 to 144 to all feed structures 166(1) to 166(M) which are vertically distributed with respect to a horizontal feed structure 166A to 166F which has a coupling with the beam former output 130 to 144 in conjunction with the horizontal distribution. That is, the vertical direction of transmitted beam is not steered.

In an embodiment, the at least one ground layer structure 204 comprises at least one reference ground layer 210 for the beam former 100, electrically controllable switches 116 to 128 and the at least two beam former inputs 102 to 114.

In an embodiment, the at least one ground layer structure 204 comprises at least one ground layer 212 for the feed network structure 148 and radiators 302. That is, the ground layer 212 is for antenna patches. The feed network reference ground may be asymmetric, and it may also utilize the additional ground layer 216 together with ground layer 212.

In an embodiment, the multi-layered printed board 200 comprises at least one electrically non-conductive layer 214 between the at least one ground layer structure 212 and second layer structure 206. The at least one non-conductive layer 214 may comprise a printed board plate without the copper layer or any other electrically conductive layer. The copper may have been removed from this layer to provide reference ground on ground layer 212 for the antenna feed network 148 and the patch antennas. The thicker the at least one non-conductive layer 214 is, the broader the bandwidth of the antenna is. Thus, with the thickness of the at least one non-conductive layer 214 the bandwidth may be controlled.

In an embodiment, the multi-layered printed board 200 comprises an additional ground layer structure 216 for protecting the second layer structure 206 from electromagnetic disturbances. There are openings in copper for antenna feeds in this layer 216. The capacitive feed patch i.e. feed structure 166 is buried and protected amongst the layers of the multilayer printed board 200.

The solder masks on both sides of the multi-layered printed board 200 may be about 25 µm thick. The first layer structure 202 may be about 545 µm thick, where the thickness of the electrically conductive pattern may be 35 µm. The at least one ground layer 204 may be about 780 µm. The second layer structure 206 may be about 545 µm thick. The additional ground layer 210 may have a thickness of about 35 µm. Thus the total thickness of the multi-layered printed board 200 may be about 1.96 mm. The total thickness is so small that it can be inserted in a very narrow place for example in radio mast.

What is explained above refers to transmission of a signal. The coupling arrangement is also suitable for reception of radio frequency signals. Then the signal received by the antenna elements 166 is fed to the network structure 148 as N sub-signals. The network structure 148 outputs the signal through its outputs 150 to 164 to beam former 100. On the basis of the electrically controllable beam former switches 116 to 128, the signal with a desired beam form may be received.

Thus, the inputs 102 to 114 of the beam former 100 may thus be also outputs. In a similar manner, the outputs 130 to 144 of the beam former 100 may be inputs. The inputs 150 to 164 of the network structure 148 may be outputs. That is, the inputs and outputs 102 to 114 and 130 to 144 are in general terminals.

Based on what has already been explained the following expresses general features of the coupling arrangement. A beam form of a radio frequency signal input to the beam former 100 is steered by the beam former 100 of the first layer structure 202 on the basis of a control signal. The beam former 100 thus performs a steered beam forming operation to a radio frequency signal passing through the beam former 100. The radio frequency signal in the steered form is conveyed by a feed network structure 148 of the second layer structure 206 between the beam former 100 and the feed structure-specific radiators 302, each of the plurality of the network terminals 150 to 164 being coupled with one beam former terminal 130 to 144. The radio frequency signal is coupled capacitively between capacitive feed structures 166 of the feed network structure 148 and feed structure-specific radiators 302 for transmitting or receiving the radio frequency signal.

As shown in Figure 4, each of the electrically controllable switches 116 to 128 may be semiconductor diodes switches which may comprise in each input of the beam former 100 a first diode switch circuit 400 and a second diode switch circuit 402 for allowing or blocking a radio frequency signal transfer from common pole 404 to an input 102 to 114 of the beam former 100. The semiconductor diode switches 116 to 128 may also comprise a first quarter wave transmission line 406 between the common pole 404 and the first diode switch circuit 400, and a second quarter wave transmission line 408 between the first diode switch circuit 400 and the second diode switch circuit 402. The first diode switch circuit 100 may comprise a diode 410 and the second diode switch circuit 402 may comprise a diode 412 and a resistor 414. Each of the electrically controllable switches 116 to 128 may be switched off and terminated by feeding a DC current through the diode switch circuits 400 and 402. The current may be about 50 mA, for example. The current may be fed through the diode switch circuits 400, 402 by applying a positive voltage over the diodes switch circuits such that the anode has a higher voltage than the cathode. Then the input 102 to 114 of the beam former 100 is in electrical contact with the ground.

Each of the electrically controllable switches 116 to 128 may be switched on by applying a negative DC voltage over the diode switch circuits 400 and 402. The voltage may be about 30 V, for example. The negative voltage over the diodes switch circuits 400 402 is such that the anode has a lower voltage than the cathode. Then the input 102 to 114 of the beam former 100 is isolated from the ground.

Figure 5 shows another example of the electronically controllable switches. In this example the diode 104 has a different coupling than in Figure 4. However, the on and off switching of the diodes 104, 106 is performed in a similar manner. The diodes could be coupled in opposite direction with respect to Figures 4 or 5, for example. Then the switching would be a little different. However, because there is a plurality of ways to couple the diodes 104, 106 which are all known to a person skilled in the art *per se,* there is no need discuss more about them. A Finnish patent document FI 20145395 deals more closely with the semiconductor switches. The control signal may come from an electronic controller 450 which may be included in the controller 180.

This kind of layered arrangement leads to an integrated and well isolated structure for antenna electrical beam steering, and a low profile antenna feed is achieved on a single board. Also good isolation against the environment may be achieved.

The multi-beam antenna structure described in this application allows simple and mechanically flat and highly integrated structure to provide switchable or continuously turnable multi-beam antenna.

The multi-beam antenna structure may be based on only two separate parts and cover. Antenna covers may be integrated or replaced with radiators 304. All the other parts may be implemented on a single printed board 200. Other parts include the antenna feed structure 148, which includes power division network to the capacitive feed structures 166, the beam former 100 and the electrically controllable switches 116 to 128.

Antenna unit may be connected to radio parts with a single radio frequency tube or the transmission line 300 such as a coaxial cable and control connector. Cables etc. separate transmission lines towards the antenna element may be avoided. The antenna feed, power divider, beam forming matrix and switches may be integrated on a single printed board 200 which is cost efficient in production.

This kind of antenna structure may be used in an integrated radio remote head or active antenna, which requires that the beam is electrically selected and steered in an efficient manner for optimal link performance. Integrated structure allows a simple, low cost, reliable, planar and easy manufacturing solution. Therefore it is easy to integrate with a radio module. The structure is also well isolated against electromagnetic disturbance because of buried feed lines behind an electrically conductive layer.

The antenna structure also allows very small variances in the performance, because the number of "moving parts" is minimized. The printed board structure 200 has very low tolerances. The only mechanically moving parts with respect to each other are the radiators 304 and the capacitive feed structures 166 i.e. antenna patches.

At least one of the following features alone or together with other features is an advantage of the multi-beam antenna:
- Highly integrated structure
- Low cost
- High reliability
- Repeatability
- Electrical beam steering
- Extremely flat structure.

The flat structure makes the antenna easy to use as a mast antenna because mast assembled radio units should be small and light. The solution in this application makes it possible to optimize size and weight issues.

Additionally the antenna elements are air filled and can be made without separate signal chain structures for each beam. These features result in at least one of the following: high gain, low loss, wide bandwidth, high efficiency, simplicity in structure and easiness in manufacturing.

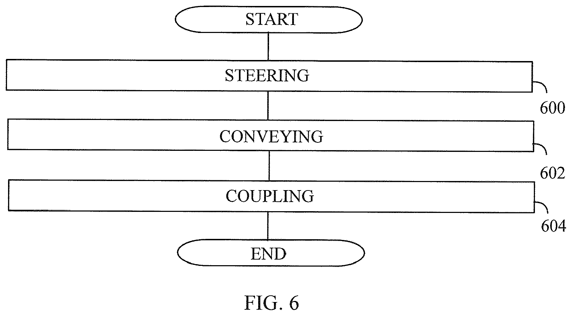

Figure 6 is a flow chart of the control method. The control method comprises steps 600, 602 and 604. In step 600, a beam form of a radio frequency signals input to the beam former 100 is steered by a beam former 100 of the first layer structure 202 on the basis of a control signal. In step 602, the radio frequency signal in the steered form is conveyed between the beam former 100 and feed structure-specific radiators 302 by a feed network structure 148 of the second layer structure 206, each of the plurality of the network terminals 150 to 164 being coupled with one beam former terminal 130 to 144. In step 604, the radio frequency signal is coupled capacitively between capacitive feed structures 166 of the feed network structure 148 and feed structure-specific radiators 302 for transmitting or receiving the radio frequency signal.

The method shown in Figure 6 may be implemented as a logic circuit solution or computer program. The computer program may be placed on a computer program distribution means for the distribution thereof. The computer program distribution means is readable by a data processing device, and it encodes the computer program commands, carries out the measurements and optionally controls the processes on the basis of the measurements.

The distribution medium, in turn, may be a medium readable by a data processing device, a program storage medium, a memory readable by a data processing device, a software distribution package readable by a data processing device, a signal readable by a data processing device, a telecommunications signal readable by a data processing device, or a compressed software package readable by a data processing device.

## Claims

1. A coupling arrangement for a radio frequency multi-beam antenna, wherein the coupling arrangement comprises a feed structure specific radiator (302) and a multi-layered printed board (200) which comprises a solder layer, a first layer structure (202), at least one ground layer structure (204) and a second layer structure (206);
the first layer structure (202) being covered with the solder layer and comprising electrically controllable semiconductor diode switches (116 to 128) and a beam former (100) comprising beam former inputs (102 to 114), wherein the beam former (100) is electrically steerable by the electrically controllable semiconductor diode switches (116 to 128) associated with the beam former (100), the beam former (100) being configured to perform a steered beam forming operation to a radio frequency signal passing through the beam former (100) with the electrically controllable semiconductor diode switches (116 to 128) configured to receive the radio frequency signal and couple the radio frequency signal to one of the beam former inputs (102 to 114) at a time on the basis of a control signal;
the electrically controllable semiconductor diodes switches (116 to 128) comprise a common pole (404) and in each input of the beam former (100) a first diode switch circuit (400) and a second diode switch circuit (402) for allowing or blocking a radio frequency signal transfer from the common pole (404) to an input (102 to 114) of the beam former (100);
the electrically controllable semiconductor diode switches (116 to 128) comprise a first quarter wave transmission line (406) between the common pole (404) and the first diode switch circuit (400), and a second quarter wave transmission line (408) between the first diode switch circuit (400) and the second diode switch circuit (402);
the first diode switch circuit (100) comprise a diode (410) and the second diode switch circuit (402) comprise a diode (412) and a resistor (414);
the second layer structure (206) comprising a feed network structure (148) and a plurality of capacitive feed structures (166), each of the plurality of the capacitive feed structures (166) and a feed structure specific radiator (302) being a patch antenna, and starting points of the feed network structure (148) being connected to the beam former (100) through a via (220);
the feed network structure (148) having a plurality of network terminals (150 to 164) each of which being coupled with one beam former terminal (130 to 144), and the feed network structure (148) having capacitive feed structures (166) for capacitively coupling the radio frequency signal to or from the feed structure-specific radiators (302) for transmitting or receiving the radio frequency signal.

2. The coupling arrangement of claim 1, wherein the beam former (100) is configured to output the radio frequency signal in a steered beam form from at least one beam former output (130 to 144); and
the feed network structure (148) having a plurality of network inputs (150 to 164) each of which being coupled with one beam former output (130 to 144), and the capacitive feed structures (166) capacitively forwarding the radio frequency signal to the feed structure-specific radiators (302).

3. The coupling arrangement of claim 1, wherein the first layer structure (202) comprising a beam former (100), which comprises at least two electrically exclusively selectable beam former inputs (102 to 114) for a radio frequency signal, and the beam former (100) being configured to output the radio frequency signal in a beam-former-input-dependent beam form from at least one beam former output (130 to 144), the beam form depending on the selected beam former input (102 to 114).

4. The coupling arrangement of claim 1, wherein the feed network structure (148) being coupled with the capacitive feed structures (166) for forwarding the radio frequency signal of the steered beam form to the feed structures (166) for transmitting the radio frequency signal via feed structure-specific radiators (302).

5. The coupling arrangement of claim 3, wherein
the electrically controllable semiconductor diode switches (116 to 128) being configured to receive the radio frequency signal and couple the radio frequency signal to one of beam former inputs (102 to 114) at a time on the basis of a control signal.

6. The coupling arrangement of claim 1, wherein the feed network structure (148) is configured to couple each beam former output (130 to 144) with one of horizontally distributed feed structures (166).

7. The coupling arrangement of claim 1, wherein the at least ground layer structure (204) comprises at least one reference ground layer (210) for the beam forming network structure (100) and the at least two beam former inputs (102 to 114).

8. The coupling arrangement of claim 1, wherein the at least ground layer structure (204) comprises at least one ground layer (212) for the feed network structure (148) and radiators (302).

9. The coupling arrangement of claim 1, wherein the multi-layered printed board (200) comprises an electrically non-conductive layer (214) between the at least one ground layer (212) and second layer structure (206).

10. The coupling arrangement of claim 1, wherein the multi-layered printed board (200) comprises an additional ground layer structure (216) for protecting the second layer structure (206) from electromagnetic disturbances.

11. A coupling method for a radio frequency multi-beam antenna, wherein a multi-layered printed board (200) comprises a first layer structure (202) covered with a solder layer and comprising electrically controllable semiconductor diode switches (116 to 128), at least one ground layer structure (204) and a second layer structure (206), and the method comprises
steering (600) a beam form of a radio frequency signals input to the beam former (100) of the first layer structure (202) by the electrically controllable semiconductor diode switches (116 to 128) which are associated with the beam former (100) such that the semiconductor diodes switches (116 to 128) comprise in each input of the beam former (100) a first diode switch circuit (400) and a second diode switch circuit (402), and a first quarter wave transmission line (406) between a common pole (404) and a first diode switch circuit (400), and a second quarter wave transmission line (408) between the first diode switch circuit (400) and a second diode switch circuit (402), where the first diode switch circuit (100) comprise a diode (410) and the second diode switch circuit (402) comprise a diode (412) and a resistor (414), the electrically controllable semiconductor diode switches (116 to 128) receiving the radio frequency signal and coupling the radio frequency signal to one of beam former inputs (102 to 114) at a time on the basis of a control signal by allowing or blocking a radio frequency signal transfer from the common pole (404) to an input (102 to 114) of the beam former (100);
conveying (602), by a feed network structure (148) of the second layer structure (206), the radio frequency signal in the steered form between the beam former (100) and feed structure-specific radiators (302), each of the plurality of the network terminals (150 to 164) being coupled with one beam former terminal (130 to 144), and each of the plurality of the capacitive feed structures (166) and a feed structure specific radiator (302) being a patch antenna, and starting points of the feed network structure (148) being connected to the beam former (100) through a via (220); and
coupling (604) the radio frequency signal capacitively between capacitive feed structures (166) of the feed network structure (148) and feed structure-specific radiators (302) for transmitting or receiving the radio frequency signal.

## Patentansprüche

1. Kopplungsanordnung für eine Hochfrequenzantenne mit mehreren Strahlungskeulen, wobei die Kopplungsanordnung einen speisestrukturspezifischen Strahler (302) und eine mehrlagige gedruckte Leiterplatte (200) aufweist, die eine Lotschicht, eine erste Schichtstruktur (202), mindestens eine Erdungsschichtstruktur (204) und eine zweite Schichtstruktur (206) aufweist;
wobei die erste Schichtstruktur (202) von der Lotschicht bedeckt ist und elektrisch steuerbare Halbleiterdiodenschalter (116 bis 128) und einen Strahlformer (100) mit Strahlformereingängen (102 bis 114) aufweist, wobei der Strahlformer (100) durch die elektrisch steuerbaren Halbleiterdiodenschalter (116 bis 128), die dem Strahlformer (100) zugeordnet sind, elektrisch lenkbar ist, wobei der Strahlformer (100) ausgebildet ist, einen Strahlformungsvorgang an einem Hochfrequenzsignal, das den Strahlformer (100) durchläuft, mit den elektrisch steuerbaren Halbleiterdiodenschaltern (116 bis 128) auszuführen, die ausgebildet sind, das Hochfrequenzsignal zu empfangen und das Hochfrequenzsignal in einen der Strahlformereingänge (102 bis 114) der Reihe nach auf der Grundlage eines Steuersignals einzukoppeln;
wobei die elektrisch steuerbaren Halbleiterdiodenschalter (116 bis 128) einen gemeinsamen Pol (404) und in jedem Eingang des Strahlformers (100) eine erste Diodenschalterschaltung (400) und eine zweite Diodenschalterschaltung (402), die ein Durchlassen oder Blockieren eines Hochfrequenzsignaltransfers von dem gemeinsamen Pol (404) zu einem Eingang (102 bis 114) des Strahlformers (100) ermöglichen, aufweisen;
wobei die elektrisch steuerbaren Halbleiterdiodenschalter (116 bis 128) eine erste Viertelwellenlängen-Übertragungsleitung (406) zwischen dem gemeinsamen Pol (404) und der ersten Diodenschalterschaltung (400) und eine zweite Viertelwellenlängen-Übertragungsleitung (408) zwischen der ersten Diodenschalterschaltung (400) und der zweiten Diodenschalterschaltung (402) aufweisen;
wobei die erste Diodenschalterschaltung (100) eine Diode (410) aufweist und die zweite Diodenschalterschaltung (402) eine Diode (412) und einen Widerstand (414) aufweist;
wobei die zweite Schichtstruktur (206) eine Speisenetzwerkstruktur (148) und mehrere kapazitive Speisestrukturen (166) aufweist, wobei jede der mehreren kapazitiven Speisestrukturen (166) und ein speisestrukturspezifischer Strahler (302) eine Patchantenne bilden, und Anfangspunkte der Speisenetzwerkstruktur (148) mit dem Strahlformer (100) über eine Kontaktdurchführung (220) verbunden sind;
wobei die Speisenetzwerkstruktur (148) mehrere Netzwerkanschlüsse (150 bis 164) hat, die jeweils mit einem Strahlformeranschluss (130 bis 144) verbunden sind, und wobei die Speisenetzwerkstruktur (148) kapazitive Speisestrukturen (166) zur kapazitiven Kopplung des Hochfrequenzsignals in oder aus den speisestrukturspezifischen Strahlern (302) zum Senden oder Empfangen des Hochfrequenzsignals aufweist.

2. Kopplungsanordnung nach Anspruch 1, wobei der Strahlformer (100) ausgebildet ist, das Hochfrequenzsignal in einer gelenkten Strahlform aus mindestens einem Strahlformerausgang (130 bis 144) auszugeben; und
die Speisenetzwerkstruktur (148) mehrere Netzwerkeingänge (150 bis 164) aufweist, wovon jeder mit einem Strahlformerausgang (130 bis 144) gekoppelt ist, und die kapazitiven Speisestrukturen (166) das Hochfrequenzsignal kapazitiv an die speisestrukturspezifischen Strahler (302) weiterleiten

3. Kopplungsanordnung nach Anspruch 1, wobei die erste Schichtstruktur (202) einen Strahlformer (100) aufweist, der mindestens zwei ausschließlich elektrisch auswählbare Strahlformereingänge (102 bis 114) für ein Hochfrequenzsignal aufweist, und wobei der Strahlformer (100) ausgebildet ist, das Hochfrequenzsignal in einer vom Strahlformereingang abhängigen Strahlform aus mindestens einem Strahlformerausgang (130 bis 144) auszugeben, wobei die Strahlform von dem ausgewählten Strahlformereingang (102 bis 114) abhängt.

4. Kopplungsanordnung nach Anspruch 1, wobei die Speisenetzwerkstruktur (148) mit den kapazitiven Speisestrukturen (166) zum Weiterleiten des Hochfrequenzsignals der gelenkten Strahlform zu den Speisestrukturen (166) gekoppelt ist, um das Hochfrequenzsignal über die speisestrukturspezifischen Strahler (302) zu senden.

5. Kopplungsanordnung nach Anspruch 3, wobei die elektrisch steuerbaren Halbleiterdiodenschalter (116 bis 128) ausgebildet sind, das Hochfrequenzsignal zu empfangen und das Hochfrequenzsignal zu einem Zeitpunkt in einen von mehreren Strahlformereingängen (102 bis 114) auf der Grundlage eines Steuersignals einzukoppeln.

6. Kopplungsanordnung nach Anspruch 1, wobei die Speisenetzwerkstruktur (148) ausgebildet ist, jeden Strahlformerausgang (130 bis 144) mit einer von mehreren horizontal verteilten Speisestrukturen (166) zu koppeln.

7. Kopplungsanordnung nach Anspruch 1, wobei die mindestens eine Erdungsschichtstruktur (204) mindestens eine Referenzerdungsschicht (210) für die Strahlformungsnetzwerkstruktur (100) und mindestens zwei Strahlformereingänge (102 bis 114) aufweist.

8. Kopplungsanordnung nach Anspruch 1, wobei die mindestens eine Erdungsschichtstruktur (204) mindestens eine Erdungsschicht (212) für die Speisenetzwerkstruktur (148) und Strahler (302) aufweist.

9. Kopplungsanordnung nach Anspruch 1, wobei die mehrlagige gedruckte Leiterplatte (200) eine elektrisch nicht-leitende Schicht (214) zwischen der mindestens einen Erdungsschicht (212) und der zweiten Schichtstruktur (206) aufweist.

10. Kopplungsanordnung nach Anspruch 1, wobei die mehrlagige gedruckte Leiterplatte (200) eine zusätzliche Erdungsschichtstruktur (216) zum Schutz der zweiten Schichtstruktur (206) vor elektromagnetischen Einflüssen aufweist.

11. Kopplungsverfahren für eine Hochfrequenzantenne mit mehreren Strahlkeulen, wobei eine mehrlagige gedruckte Leiterplatte (200) eine erste Schichtstruktur (202), die mit einer Lotschicht bedeckt ist und elektrisch steuerbare Halbleiterdiodenschalter (116 bis 128) aufweist, und mindestens eine Erdnungsschichtstruktur (204) und eine zweite Schichtstruktur (206) aufweist, und wobei das Verfahren umfasst:
Lenken (600) einer Strahlform eines Hochfrequenzsignaleingangs zu dem Strahlformer (100) der ersten Schichtstruktur (202) durch die elektrisch steuerbaren Halbleiterdiodenschalter (116 bis 128), die dem Strahlformer (100) derart zugeordnet sind, dass die Halbleiterdiodenschalter (166 bis 128) in jedem Eingang des Strahlformers (100) eine erste Diodenschalterschaltung (400) und eine zweite Diodenschalterschaltung (402) aufweisen, und eine erste Viertelwellenlänge-Übertragungsleitung (406) zwischen einem gemeinsamen Pol (404) und der ersten Diodenschalterschaltung (400) und eine zweite Viertelwellenlängen-Übertragungsleitung (408) zwischen der ersten Diodenschalterschaltung (400) und der zweiten Diodenschalterschaltung (402) liegt, wobei die erste Diodenschalterschaltung (400) eine Diode (410) und die zweite Diodenschalterschaltung (402) eine Diode (412) und einen Widerstand (414) aufweist, wobei die elektrisch steuerbaren Halbleiterdiodenschalter (116 bis 128) das Hochfrequenzsignal empfangen und das Hochfrequenzsignal in einen von mehreren Strahlformereingängen (102 bis 114) nacheinander auf der Grundlage eines Steuersignals einkoppeln, indem ein Hochfrequenzsignalübergang von dem gemeinsamen Pol (404) zu einem Eingang (102 bis 114) des Strahlformers (100) durchgelassen oder blockiert wird;
Transportieren (602), mittels einer Speisenetzwerkstruktur (148) der zweiten Schichtstruktur (206), des Hochfrequenzsignals in der gelenkten Form zwischen dem Strahlformer (100) und speisestrukturspezifischen Strahlern (302), wobei jeder der mehreren Netzwerkanschlüsse (150 bis 164) mit einem Strahlformeranschluss (130 bis 144) gekoppelt ist, und wobei jede der mehreren der kapazitiven Speisestrukturen (166) und ein speisestrukturspezifischer Strahler (302) eine Patchantenne bilden, und Anfangspunkte der Speisenetzwerkstruktur (148) über eine Kontaktdurchführung (220) mit dem Strahlformer (100) verbunden sind; und
Koppeln (604) des Hochfrequenzsignals kapazitiv zwischen kapazitiven Speisestrukturen (166) der Speisenetzwerkstruktur (148) und speisestrukturspezifischen Strahlern (302) zum Senden oder Empfangen des Hochfrequenzsignals.

## Revendications

1. Agencement de couplage pour une antenne radiofréquence à plusieurs lobes, dans lequel l'agencement de couplage comprend un radiateur spécifique à la structure d'alimentation (302) et une carte imprimée multicouche (200) qui comprend une couche de brasage,
une première structure de couche (202), au moins une structure de couche de base (204) et une seconde structure de couche (206);
la première structure de couche (202) étant recouverte de la couche de brasage et comprenant des commutateurs à diodes semi-conductrices à commande électrique (116 à 128) et un formateur de faisceau (100) comprenant des entrées de formateur de faisceau (102 à 114), dans lequel le formateur de faisceau (100) est électriquement orientable par les commutateurs à diodes semi-conductrices à commande électrique (116 à 128) associés au formateur de faisceau (100), le formateur de faisceau (100) étant configuré pour effectuer une opération de formation de faisceau dirigé sur un signal radiofréquence traversant le formateur de faisceau (100) avec les commutateurs à diodes semi-conductrices à commande électrique (116 à 128) configurés pour recevoir le signal radiofréquence et coupler le signal radiofréquence à l'une des entrées de formateur de faisceau (102 à 114) à la fois sur la base d'un signal de commande;
les commutateurs à diodes semi-conductrices à commande électrique (116 à 128) comprennent un pôle commun (404) et
dans chaque entrée du formateur de faisceau (100), un premier circuit de commutation de diode (400) et un second circuit de commutation de diode (402) pour autoriser ou bloquer un transfert de signal radiofréquence en provenance du pôle commun (404) vers une entrée (102 à 114) du formateur de faisceau (100);
les commutateurs à diodes semi-conductrices à commande électrique (116 à 128) comprennent une première ligne de transmission quart d'onde (406) entre le pôle commun (404) et le premier circuit de commutation de diode (400), et une seconde ligne de transmission quart d'onde (408) entre le premier circuit de commutation de diode (400) et le second circuit de commutation de diode (402);
le premier circuit de commutation de diode (100) comprend une diode (410) et le second circuit de commutation de diode (402) comprend une diode (412) et une résistance (414);
la seconde structure de couche (206) comprenant une structure de réseau d'alimentation (148) et une pluralité de structures d'alimentation capacitives (166), chacune de la pluralité des structures d'alimentation capacitives (166) et un radiateur spécifique de structure d'alimentation (302) étant une antenne planaire, et les points de départ de la structure de réseau d'alimentation (148) étant connectés au formateur de faisceau (100) à travers un via (220);
la structure de réseau d'alimentation (148) ayant une pluralité de terminaux de réseau (150 à 164), chacun d'entre eux étant couplé à un premier terminal de formateur de faisceau (130 à 144), et la structure de réseau d'alimentation (148) ayant des structures d'alimentation capacitives (166) pour coupler de manière capacitive le signal radiofréquence vers ou bien en provenance des radiateurs (302) spécifiques aux structure d'alimentation pour émettre ou recevoir le signal radiofréquence.

2. Agencement de couplage selon la revendication 1, dans lequel le formateur de faisceau (100) est configuré pour délivrer le signal radiofréquence sous forme de faisceau dirigé à partir d'au moins une sortie de formateur de faisceau (130 à 144); et
la structure de réseau d'alimentation (148) ayant une pluralité d'entrées de réseau (150 à 164), couplées chacune à une sortie de formateur de faisceau (130 à 144), et les structures d'alimentation capacitives (166) acheminant de manière capacitive le signal radiofréquence vers les radiateurs (302) spécifiques aux structures d'alimentation.

3. Agencement de couplage de la revendication 1, dans lequel la première structure de couche (202) comprenant un formateur de faisceau (100), qui comprend au moins deux entrées de formateur de faisceau (102 à 114) exclusivement sélectionnables pour un signal radiofréquence, le formateur de faisceau (100) étant configuré pour émettre le signal radiofréquence sous forme d'un faisceau dépendant d'une entrée de formateur de faisceau à partir d'au moins une sortie de formateur de faisceau (130 à 144), la forme du faisceau dépendant de l'entrée de formateur de faisceau sélectionné (102 à 114).

4. Agencement de couplage selon la revendication 1, dans lequel la structure de réseau d'alimentation (148) est couplée aux structures d'alimentation capacitives (166) pour transmettre le signal radiofréquence de la forme de faisceau dirigé vers les structures d'alimentation (166) pour transmettre le signal radiofréquence par l'intermédiaire de radiateurs (302) spécifiques aux structures d'alimentation.

5. Agencement de couplage de la revendication 3, dans lequel les commutateurs à diodes semi-conductrices à commande électrique (116 à 128) étant configurés pour recevoir le signal radiofréquence et coupler le signal radiofréquence à l'une des entrées de formateur de faisceau (102 à 114) à la fois sur la base d'un signal de commande.

6. Agencement de couplage de la revendication 1, dans lequel la structure de réseau d'alimentation (148) est configurée pour coupler chaque sortie de formateur de faisceau (130 à 144) avec l'une des structures d'alimentation distribuées horizontalement (166).

7. Agencement de couplage de la revendication 1, dans lequel ladite au moins une structure de couche de base (204) comprend au moins une couche de base de référence (210) pour la structure de réseau de formation de faisceau (100) et lesdites au moins deux entrées de formateur de faisceau (102 à 114).

8. Agencement de couplage selon la revendication 1, dans lequel ladite au moins une structure (204) de la couche de base comprend au moins une couche de base (212) pour la structure de réseau d'alimentation (148) et les radiateurs (302).

9. Agencement de couplage selon la revendication 1, dans lequel la carte imprimée multicouche (200) comprend une couche électriquement non conductrice (214) entre ladite au moins une couche de base (212) et la seconde structure de couche (206).

10. Agencement de couplage selon la revendication 1, dans lequel la carte imprimée multicouche (200) comprend une structure de couche de base supplémentaire (216) pour protéger la seconde structure de couche (206) des perturbations électromagnétiques.

11. Procédé de couplage pour une antenne radiofréquence à plusieurs lobes, dans lequel une carte imprimée multicouche (200) comprend une première structure de couche (202) recouverte d'une couche de brasage et comprenant des commutateurs à diodes semi-conductrices à commande électrique (116 à 128), au moins une structure de couche de base (204) et une seconde structure de couche (206), et le procédé consiste à
diriger (600) une forme de faisceau d'un des signaux radiofréquence entrés dans le formateur de faisceau (100) de la première structure de couche (202) par les commutateurs à diodes semi-conductrices à commande électrique (116 à 128) qui sont associés au formateur de faisceau (100) de sorte que les commutateurs à diodes semi-conductrices (116 à 128) comprennent dans chaque entrée du formateur de faisceau (100) un premier circuit de commutation de diode (400) et un second circuit de commutation de diode (402), et une première ligne de transmission quart d'onde (406) entre un pôle commun (404) et un premier circuit de commutation de diode (400), et une seconde ligne de transmission quart d'onde (408) entre le premier circuit de commutation de diode (400) et un second circuit de commutation de diode (402), où le premier circuit de commutation de diode (100) comprend une diode (410) et le second circuit de commutation de diode (402) comprend une diode (412) et une résistance (414), les commutateurs à diodes semi-conductrices à commande électrique (116 à 128) recevant le signal radiofréquence et couplant le signal radiofréquence à l'une des entrées (102 à 114) de formateur de faisceau à la fois sur la base d'un signal de commande en autorisant ou bloquant un transfert de signal radiofréquence depuis le pôle commun (404) vers une entrée (102 à 114) du formateur de faisceau (100);
transportant (602), par une structure de réseau d'alimentation (148) de la seconde structure de couche (206), le signal radiofréquence dans la forme dirigée entre le formateur de faisceau (100) et les radiateurs (302) spécifiques à la structure d'alimentation, chacun de la pluralité des terminaux de réseau (150 à 164) étant couplé à un terminal du formateur de faisceau (130 à 144), chacune de la pluralité des structures d'alimentation capacitives (166) et un radiateur (302) spécifique de structure d'alimentation étant une antenne planaire, et les points de départ de la structure de réseau d'alimentation (148) étant connectés au formateur de faisceau (100) à travers un via (220); et
coupler (604) le signal de radiofréquence de façon capacitive entre les structures d'alimentation capacitives (166) de structure de réseau d'alimentation (148) et les radiateurs (302) spécifiques de structure d'alimentation pour émettre ou recevoir le signal radiofréquence.
